# EUROPÄISCHE PATENTANMELDUNG

(11) **EP 3 018 826 A1**
(43) Veröffentlichungstag der Anmeldung: **11.05.2016**
(21) Anmeldenummer: 15192949.4
(22) Anmeldetag: 04.11.2015
(51) Int. Cl.: H03K 17/96

(54) **MENSCH-MASCHINE-SCHNITTSTELLE UND VERFAHREN ZUM ÄNDERN EINER VISUELLEN MARKIERUNG EINER SCHALTFLÄCHE EINER MENSCH-MASCHINE-SCHNITTSTELLE**

(30) Priorität: 10.11.2014 EP 14192488
(71) Anmelder: Algra Holding AG, 6340 Cham (CH)
(72) Erfinder: Matter, Dieter, 4800 Zofingen (CH); Mumenthaler, Sven, 8908 Hedingen (CH); Meli, Marcel, 8700 Küsnacht (CH)
(74) Vertreter: Kasche, André

(57) **Zusammenfassung**

Die Erfindung betrifft eine Mensch-Maschine-Schnittstelle (1) zum Steuern einer Vorrichtung (3),

Die Mensch-Maschine-Schnittstelle (1) ist dazu mit:
- einer durch eine Betätigungskraft (5) betätigbaren Schaltfläche (7),
- einem zumindest während eines Einwirkens der Betätigungskraft (5) mit der Schaltfläche (7) mechanisch gekoppelten elektromechanischen Wandler (9) zum Wandeln einer durch die Betätigungskraft (5) bewirkbaren mechanischen Energiemenge (13) in eine elektrische Energiemenge (15),
- einer Anzeigevorrichtung (17), mittels der eine visuelle Markierung (19) der Schaltfläche (7) im Wesentlichen stromlos darstellbar ist,
ausgestattet. Die visuelle Markierung (19) ist in Abhängigkeit von der mittels des elektromechanischen Wandlers (9) erzeugbaren elektrische Energiemenge (15) änderbar.

## Beschreibung

Die Erfindung betrifft eine Mensch-Maschine-Schnittstelle zum Steuern einer Vorrichtung und ein Verfahren zum Ändern einer visuellen Markierung einer durch eine Betätigungskraft betätigbaren Schaltfläche der Mensch-Maschine-Schnittstelle.

Mensch-Maschine-Schnittstellen sowie Verfahren zum Ändern von visuellen Markierungen von Schaltflächen von Mensch-Maschine-Schnittstellen sind bekannt. Als MenschMaschine-Schnittstelle können insbesondere berührungssensitive Bildschirme verwendet werden. Dabei ist es möglich, dass visuelle Markierungen von betätigbaren Schaltflächen durch entsprechende Programmabläufe grafisch auf dem berührungssensitiven Bildschirm dargestellt werden. Bei solchen Mensch-Maschine-Schnittstellen ist es möglich, dass betätigungs- und/oder funktionsbedingte Rückmeldungen, beispielsweise nach einem Drücken einer solchen grafisch dargestellten Schaltfläche durch ein Ändern einer bei oder auf der Schaltfläche dargestellten Grafik erfolgt. Außerdem sind Mensch-Maschine-Schnittstellen bekannt, die Bedienereingaben mittels fest verdrahteten elektrischen Aufnehmern und diesen zugeordneten Schaltflächen aufnehmen. In diesem Fall können funktions- und/oder betätigungsbedingte Rückmeldungen durch entsprechende Ausgabevorrichtungen auf haptischem, visuellem und/oder akustischem Wege erfolgen, wobei dazu der Schaltfläche entsprechende Ausgabevorrichtungen zuordenbar sind. Die fest verdrahteten Aufnehmer können auf unterschiedlichste Weise realisiert werden, beispielsweise als Schalter, kapazitive, resistive, induktive Aufnehmer. Ebenso kann als Aufnehmer ein piezoelektrisches Element zum Einsatz kommen, das eine auf dieses wirkende Betätigungskraft in eine elektrische Energiemenge zum Bewirken eines entsprechenden Schaltvorgangs wandelt. Aus der DE 693 04 443 T2 ist beispielsweise ein Verfahren zur Herstellung einer piezoelektrischen drucksensitiven Taste oder Tastatur und durch dieses Verfahren erhältliches Produkt bekannt.

Aufgabe der Erfindung ist es, eine gegen Fehlbedienungen und mechanische Einflüsse möglichst robuste, stromsparende und gleichzeitig gut ablesbare, insbesondere bei hellem Umgebungslicht, Mensch-Maschine-Schnittstelle sowie ein Verfahren zum Betreiben derselben bereitzustellen.

Die Aufgabe ist durch eine Mensch-Maschine-Schnittstelle zum Steuern einer Vorrichtung, mit einer durch eine Betätigungskraft betätigbaren Schaltfläche, einem zumindest während eines Einwirkens der Betätigungskraft mit der Schaltfläche mechanisch gekoppelten elektromechanischen Wandler zum Wandeln einer durch die Betätigungskraft bewirkbaren mechanischen Energiemenge in eine elektrische Energiemenge und einer Anzeigevorrichtung mittels der eine visuelle Markierung der Schaltfläche, insbesondere im Wesentlichen stromlos, darstellbar ist, wobei die visuelle Markierung in Abhängigkeit von der mittels des elektromechanischen Wandlers erzeugbaren elektrischen Energiemenge änderbar ist, gelöst.

Elektromechanische Wandler können vorteilhaft robust gegen mechanische Belastungen und mögliche Fehlauslösungen ausgelegt werden. In Kombination mit der im Wesentlichen stromlosen Darstellung mittels der Anzeigevorrichtung lässt sich die visuelle Markierung der Schaltfläche gut ablesen, insbesondere aus den unterschiedlichsten Blickwinkeln, wobei gleichzeitig ein besonders stromsparender Betrieb der Mensch-Maschine-Schnittstelle möglich ist. Insbesondere kann die visuelle Markierung bei hellem Umgebungslicht gut abgelesen werden. Unter einer im Wesentlichen stromlosen Darstellung kann verstanden werden, dass die Anzeigevorrichtung zum Darstellen der visuellen Markierung keinen oder zumindest nur einen minimalen Stromverbrauch aufweist. Dazu kann die Anzeigevorrichtung als sogenannte reflektive Anzeigevorrichtung ausgestaltet sein, die auf sie einfallendes Licht reflektiert, also keine eigene Beleuchtung benötigt. Insbesondere kann die Anzeigevorrichtung zum stromlosen Darstellen der visuellen Markierung ein Elektrophoreseprinzip, bistabile LCD, eine Elektrobenetzung und/oder eine mikromechanisch gesteuerte Interferenzmodulation oder eine als elektronisches Papier bekannte Vorrichtung im Allgemeinen aufweisen. Unter im Wesentlichen stromlos kann insbesondere eine elektrisch passive Darstellung verstanden werden, wobei lediglich zum Ändern der visuellen Markierung ein Stromfluss benötigt wird. Ferner kann unter stromlos verstanden werden, dass nicht mit der Anzeigevorrichtung direkt im Zusammenhang stehende Lichtquellen zur Beleuchtung der Anzeigevorrichtung verwendet werden. Insbesondere kann darunter auch verstanden werden, dass die Anzeigevorrichtung in einem Stromsparmodus reflektiv und in einem weiteren Modus transreflektiv betreibbar ist. Besonders vorteilhaft ist es denkbar, dass die Anzeigevorrichtung grundsätzlich oder zumindest falls gewünscht die visuelle Markierung ohne wesentlichen elektrischen Energieverbrauch darstellt, insbesondere diese visuelle Markierung reflektiv darstellt. Alternativ ist es jedoch auch denkbar, dass es sich bei der Anzeigevorrichtung um eine beliebige andere Anzeigevorrichtung handelt, die zum Darstellen der visuellen Markierung elektrischen Strom benötigt. Insbesondere ist die Anzeigevorrichtung direkt unter der Schaltfläche und/oder zumindest benachbart zu der Schaltfläche angeordnet. Insbesondere ist die Anzeigevorrichtung durch die Schaltfläche hindurch ablesbar. Vorteilhaft ist dadurch die eigentliche visuelle Markierung möglichst dicht, insbesondere direkt benachbart, an einer, insbesondere von einer Person, zum Zwecke einer Betätigung berührbare Oberfläche der Schaltfläche angeordnet, wobei die Ablesbarkeit dadurch besonders gut ist. Vorteilhaft bewirkt die mittels des elektromechanischen Wandlers erzeugbare elektrische Energiemenge die Änderung der visuellen Markierung. Dies erfolgt insbesondere lediglich durch ein Weiterleiten der elektrischen Energiemenge und/oder durch eine logische Verarbeitung, insbesondere mittels entsprechenden Schaltkreisen, der elektrischen Energiemenge, wobei als Ergebnis der logischen Verarbeitung das eigentliche Ändern der visuellen Markierung erfolgen kann. Vorteilhaft kann dadurch trotz einer vorzugsweisen festen Verdrahtung des vorgesehenen elektromechanischen Wandlers eine flexible visuelle Markierung der Schaltfläche erfolgen. Insbesondere kann durch eine dem elektromechanischen Wandler nachgeschaltete logische Schaltung eine frei programmierbare visuelle Markierung der Schaltfläche ermöglicht werden. Vorteilhaft kann dadurch die Mensch-Maschine-Schnittstelle für unterschiedlichste Anwendungen konfiguriert werden. Insbesondere können Tasten/Schaltflächen auf einfache Art und Weise mehrfach belegt und dazu entsprechend markiert werden. Insbesondere ist es denkbar, dass mittels der Mensch-Maschine-Schnittstelle unterschiedlichste Steueraufgaben an unterschiedlichsten Vorrichtungen bewerkstelligt werden, wobei jeweils an die Vorrichtung angepasste funktionsbedingte und/oder betätigungsbedingte Rückmeldungen an der Schaltfläche denkbar sind. Insbesondere weist die Mensch-Maschine-Schnittstelle eine oder mehrere der Schaltflächen und dementsprechend eine oder mehrere der zugeordneten elektromechanischen Wandler auf. Insbesondere kann auf diese Art und Weise eine interaktive Tastatur realisiert werden.

Bei einem Ausführungsbeispiel der Mensch-Maschine-Schnittstelle ist vorgesehen, dass die Anzeigevorrichtung zwischen der Schaltfläche und dem elektromechanischen Wandler angeordnet ist. Vorteilhaft ist die Anzeigevorrichtung möglichst nahe an der zu markierenden Schaltfläche angeordnet. Insbesondere muss im Vergleich zu herkömmlichen berührungsintensiven Bildschirmen die Darstellung nicht durch den elektromechanischen Wandler hindurch erfolgen. Vorteilhaft kann dadurch die Anzeigevorrichtung drei Aufgaben übernehmen, nämlich die Weiterleitung der Betätigungskraft und damit der mechanischen Energiemenge auf den elektromechanischen Wandler, die Darstellung der Markierung der Schaltfläche und das Wechseln der Markierung der Schaltfläche in Abhängigkeit der elektrischen Energiemenge und damit der eigentlichen Betätigung der Schaltfläche. Insbesondere ist die Schaltfläche selbst transparent, sodass das Betrachten der Anzeigevorrichtung durch die Schaltfläche hindurch möglich ist, wobei bei einem Benutzer der Mensch-Maschine-Schnittstelle der Eindruck entsteht, dass die Schaltfläche selbst visuell markiert ist. Unter visuell markiert kann jede Art von optisch wahrnehmbarer Gestaltung verstanden werden, insbesondere kann darunter eine Beschriftung, eine farbliche Markierung, ein Aufblinken, ein rhythmischer oder einfacher Farb- und/oder Kontrastwechsel und/oder Ähnliches verstanden werden. Insbesondere kann die Anzeigevorrichtung und dadurch die visuelle Markierung aufgrund der Anordnung zwischen der Schaltfläche und dem elektromechanischen Wandler auch aus sehr flachen Blickwinkeln besonders gut abgelesen werden.

Bei einem weiteren Ausführungsbeispiel der Mensch-Maschine-Schnittstelle weist die Mensch-Maschine-Schnittstelle eine dem elektromechanischen Wandler nachgeschaltete und der Anzeigevorrichtung vorgeschaltete Steuervorrichtung auf, wobei die visuelle Kennzeichnung mittels der Steuervorrichtung änderbar ist. Vorteilhaft ist zwischen den elektromechanischen Wandler und die Anzeigevorrichtung die Steuervorrichtung geschaltet, die die eigentliche Änderung der visuellen Kennzeichnung steuert. Vorteilhaft kann dies in Abhängigkeit der elektrischen Energiemenge erfolgen. Die elektrische Energiemenge kann in diesem Fall vorteilhaft als Steuerenergie angesehen beziehungsweise verwendet werden, die als Eingangsgröße der Steuervorrichtung dient. Vorteilhaft ist diese unabhängig von einer externen Stromversorgung lediglich durch ein Betätigen des elektromechanischen Wandlers erzeugbar. Vorteilhaft ist schon dadurch ein energieärmerer Betrieb der Mensch-Maschine-Schnittstelle möglich.

Bei einem weiteren Ausführungsbeispiel der Mensch-Maschine-Schnittstelle ist vorgesehen, dass die Steuervorrichtung während eines Änderns der visuellen Markierung ausschließlich durch die mittels des elektromechanischen Wandlers erzeugbare elektrische Energiemenge elektrisch versorgbar ist. Vorteilhaft kann in diesem Fall die elektrische Energiemenge gleichzeitig als Steuerenergie zum Ansteuern der Steuervorrichtung und als Hilfsenergie zum eigentlichen Betreiben bzw. elektrischen Versorgen der Steuervorrichtung dienen. Vorteilhaft kann dadurch die Mensch-Maschine-Schnittstelle energieautark oder zumindest im Wesentlichen energieautark betrieben werden. Zum Ändern der visuellen Markierung ist also vorteilhaft keine externe Energieversorgung der Steuervorrichtung und/oder der Mensch-Maschine-Schnittstelle als solches erforderlich. Dennoch kann vorteilhaft die funktions- und/oder betätigungsbedingte Rückmeldung an der Schaltfläche erfolgen. Dies ist insbesondere für Anwendungen vorteilhaft, bei denen ein zusätzlicher Verkabelungsaufwand für eine externe Energieversorgung sehr aufwändig wäre.

Bei einem weiteren Ausführungsbeispiel der Mensch-Maschine-Schnittstelle ist vorgesehen, dass die Steuervorrichtung einen dem elektromechanischen Wandler nachgeschalteten Interrupteingang aufweist, der durch die mittels des elektromechanischen Wandlers erzeugbare elektrische Energiemenge ansteuerbar ist. Vorteilhaft kann durch ein Weiterleiten der elektrischen Energiemenge an den Interrupteingang bzw. durch das Anliegen einer entsprechenden bei einer Betätigung der Schaltfläche durch den elektromechanischen Wandler erzeugten Spannung an der Steuervorrichtung ein Interrupt ausgelöst werden. Dieser kann vorteilhaft zum Wecken bzw. zum Wechseln der Steuervorrichtung von einem verbrauchsarmen Betriebszustand hin zu einem aktiven Betriebszustand verwendet werden. Unter einem energiearmen Betriebszustand kann verstanden werden, dass die Steuervorrichtung keine oder zumindest eine äußerst geringe Menge an elektrischer Energie verbraucht. Unter einem aktiven Betriebszustand kann verstanden werden, dass die Steuervorrichtung aktiv ist, insbesondere dahingehend aktiv ist, das Ändern der visuellen Markierung zu steuern und/oder zu bewirken. Während des aktiven Zustandes ist es möglich, dass die Steuervorrichtung mittels einer Hilfsenergiequelle versorgt wird. Alternativ oder zusätzlich ist es denkbar, dass die elektrische Energiemenge zunächst zum Bereitstellen der elektrischen Versorgung und gleichzeitig zum Auslösen des Interrupts der Steuervorrichtung verwendet wird.

Ein weiteres Ausführungsbeispiel der Mensch-Maschine-Schnittstelle weist eine Hilfsenergiequelle zum elektrischen Versorgen der Steuervorrichtung auf. Die Hilfsenergiequelle ist mittels einer Schaltvorrichtung von der Steuervorrichtung abtrennbar, wobei die Schaltvorrichtung dem elektromechanischen Wandler nachgeschaltet und durch diesen steuerbar ist. Die Hilfsenergiequelle ist vorteilhaft von der Steuervorrichtung wahlweise abtrennbar an diese elektrisch angeschlossen. Vorteilhaft kann mittels der Schaltvorrichtung die Hilfsenergiequelle von der Steuervorrichtung getrennt werden, sodass diese quasi stromlos geschaltet werden kann. Vorteilhaft kann dadurch zusätzlich ein sonst möglicherweise an der Steuervorrichtung auftretender Leckstrom ganz oder zumindest größtenteils eliminiert werden, wodurch eine besonders energiesparend betreibbare Mensch-Maschine-Schnittstelle möglich ist. Vorteilhaft kann die elektrische Energiemenge als Steuerenergie zum Betätigen der Schaltvorrichtung verwendet werden. Vorteilhaft kann bei einem Vorhandensein der elektrischen Energiemenge die Schaltvorrichtung leitend geschaltet werden, sodass die Hilfsenergiequelle an die Steuervorrichtung angeschlossen ist, also die Steuervorrichtung mittels der Hilfsenergiequelle elektrisch versorgbar ist. Für den Fall, dass die elektrische Energiemenge verbraucht ist, kann die Schaltvorrichtung sperrend geschaltet werden, sodass die Steuervorrichtung von der Hilfsenergiequelle abgetrennt ist. Alternativ oder zusätzlich kann die Schaltvorrichtung bistabil ausgelegt sein, insbesondere nach einem Zeitablauf nach einem einmaligen Vorhandensein bzw. Anliegen der elektrischen Energiemenge wieder auf einen sperrenden Zustand zurückfallen. Die Schaltvorrichtung kann vorteilhaft besonders leckstromarme Schaltelemente, insbesondere Transistoren aufweisen. Dadurch ist ein besonders energiearmer Betrieb der Schaltvorrichtung und der Steuervorrichtung und damit der Mensch-Maschine-Schnittstelle möglich.

Bei einem weiteren Ausführungsbeispiel der Mensch-Maschine-Schnittstelle ist vorgesehen, dass die Anzeigevorrichtung unter Einwirkung der Betätigungskraft reversibel elastisch verformbar ist. Unter elastisch verformbar kann verstanden werden, dass nach einem Einwirken der Betätigungskraft die Anzeigevorrichtung wieder ihre ursprüngliche Form und/oder Lage einnimmt. Vorteilhaft kann dadurch ein Weiterleiten der Betätigungskraft und damit der mechanischen Energiemenge auf den elektromechanischen Wandler erfolgen. Vorteilhaft übernimmt dadurch die Anzeigevorrichtung mehrere Funktionen, insbesondere das Weiterleiten der Betätigungskraft bzw. der mechanischen Energiemenge, die im Wesentlichen stromlose visuelle Markierung der Schaltfläche und das Ändern der Markierung. Insbesondere ist dadurch ein besonders kompakter Aufbau bei einer dennoch guten Ablesbarkeit der visuellen Markierung gegeben, da etwaige sonst zum Erfüllen der genannten Funktionen erforderliche Elemente entfallen können.

Bei einem weiteren Ausführungsbeispiel der Mensch-Maschine-Schnittstelle ist vorgesehen, dass der elektromechanische Wandler einen druck- und/oder verformungsempfindlichen Sensor und/oder einen piezoresistiven Sensor und/oder einen Force Sensing Resistor (FSR) und/oder ein piezoelektrisches Element aufweist und/oder die Darstellung mittels der Anzeigevorrichtung im Wesentlichen stromlos erfolgt. Unter einem piezoelektrischen Element kann ein beliebiges Material verstanden werden, das unter Einwirkung von mechanischer Energie diese in elektrische Energie wandelt und/oder umgekehrt. Insbesondere kann das piezoelektrische Element ein Piezoelektrischer Kristall, eine piezoelektrische Keramik und/oder einen Piezoelektrischen Lack und/oder ein andere/s piezoelektrische/s Material/ien aufweisen. Vorteilhaft liefert das piezoelektrische Element als Wirkung der Betätigungskraft zumindest die zum Steuern der Steuervorrichtung erforderliche Steuerenergie. Bei einer besonders vorteilhaften Alternative liefert das piezoelektrische Element neben der Steuerenergie auch vorteilhaft die erforderliche Stell- bzw. Hilfsenergie zum elektrischen Versorgen der Steuervorrichtung bzw. der Mensch-Maschine-Schnittstelle selbst, insbesondere inclusive der der Steuervorrichtung nachgaschalteten Anzeigevorrichtung der Mensch-Maschine-Schnittstelle. Es ist denkbar, dass benachbart zu der Anzeigevorrichtung eine transparente Schicht angeordnet ist, die insbesondere eine Schutzfunktion übernimmt und/oder die Schaltfläche aufweist und/oder bildet. Alternativ dazu ist es denkbar, dass eine Oberfläche der Anzeigevorrichtung selbst die Schaltfläche aufweist und/oder bildet. Dadurch ist ein noch schlankerer bzw. kleiner bauender Aufbau der Mensch-Maschine-Schnittstelle möglich.

Die Aufgabe ist außerdem durch ein Verfahren zum Ändern einer visuellen Markierung einer durch eine Betätigungskraft betätigbaren Schaltfläche einer Mensch-Maschine-Schnittstelle, insbesondere eine vorab beschriebene Mensch-Maschine-Schnittstelle, mit Bereitstellen eines elektromechanischen Wandlers zum Wandeln einer mechanischen Energiemenge in eine elektrische Energiemenge, Leiten der Betätigungskraft von der Schaltfläche auf den elektromechanischen Wandler, und dadurch Übertragen der von der Betätigungskraft bewirkten mechanischen Energiemenge auf den elektromechanischen Wandler, Wandeln der mechanischen Energiemenge in die elektrische Energiemenge mittels des elektromechanischen Wandlers, Ändern der visuellen Markierung in Abhängigkeit von der mittels des elektromechanischen Wandlers erzeugten elektrischen Energiemenge gelöst. Vorteilhaft kann dadurch eine interaktive Mensch-Maschine-Schnittstelle realisiert werden, die insbesondere eine funktions- und/oder betätigungsbedingte Rückmeldung ermöglicht, dank des elektromechanischen Wandlers einen robusten mechanischen Aufbau aufweist und eine geringe Fehlauslösungsrate ermöglicht. Vorteilhaft bewirkt ein Betätigen der Schaltfläche über den elektromechanisch en Wandler das Bereitstellen der elektrischen Energiemenge, die vorteilhaft zum Steuern der Markierung, insbesondere zum Ändern der Markierung, zur Verfügung steht. Vorteilhaft ist es denkbar, dass das Anzeigen der visuellen Markierung stromlos erfolgt, insbesondere mittels einer unter dem Begriff elektronisches Papier bekannten Vorrichtung.

Bei einer Ausführungsform des Verfahrens ist ein Leiten der Betätigungskraft von der Schaltfläche auf eine Anzeigevorrichtung zum Darstellen der Kennzeichnung und Weiterleiten der Betätigungskraft von der Anzeigevorrichtung auf den elektromechanischen Wandler vorgesehen. Vorteilhaft übernimmt die Anzeigevorrichtung die Funktion des Anzeigens sowie Änderns der Markierung und dient gleichzeitig zum Weiterleiten der Betätigungskraft. Vorteilhaft kann dadurch die Anzeigevorrichtung zwischen der Schaltfläche und dem elektromechanischen Wandler angeordnet sein. Vorteilhaft kann dadurch das Anzeigen der Markierung und/oder das Ablesen der Markierung durch die Schaltfläche hindurch erfolgen. Vorteilhaft kann dadurch ein besseres Bild bzw. eine bessere Darstellung der Markierung erzielt werden, da diese im Vergleich zu herkömmlichen Anzeigevorrichtungen nicht durch elektrische Aufnehmer wie Widerstände und/oder Kapazitäten hindurch erfolgen muss. Vorteilhaft kann der Fluss der mechanischen Energiemenge von der Schaltfläche über die Anzeigevorrichtung erfolgen. Insbesondere kann dazu die Anzeigevorrichtung elastische Eigenschaften aufweisen, insbesondere sich dazu reversibel verformen. Insbesondere ist es denkbar, dass das eigentliche Ändern der visuellen Markierung mittels einer der Anzeigevorrichtung vorgeschalteten und dem elektromechanischen Wandler nachgeschalteten Steuervorrichtung erfolgt. Ein entsprechender Energiefluss findet also von der Schaltfläche über die Anzeigevorrichtung, den elektromechanischen Wandler und von dort in Form von elektrischer Energie weiter über die Steuervorrichtung hin zur Anzeigevorrichtung statt. Vorteilhaft ist dadurch ein durchgängiger Energiefluss von der durch die Betätigungskraft bewirkten mechanischen Energiemenge hin zu der elektrischen Energiemenge möglich, die insbesondere zum Ändern der visuellen Markierung verwendet werden kann.

Bei einer weiteren Ausführungsform des Verfahrens ist ein Wechseln einer Steuervorrichtung zum Ändern der visuellen Markierung von einem energiesparenden Betriebszustand in einen aktiven Betriebszustand in Abhängigkeit der mittels des elektromechanischen Wandlers erzeugten elektrischen Energiemenge vorgesehen. Vorteilhaft kann, sobald die elektrische Energiemenge vorhanden ist, insbesondere diese der Steuervorrichtung zur Verfügung steht, das Umschalten des Betriebszustandes erfolgen. Sobald die elektrische Energiemenge nicht mehr zur Verfügung steht, kann ein Zurückschalten in den energiesparenden Zustand erfolgen. Insbesondere kann dies dann erfolgen, sobald die elektrische Energiemenge verbraucht ist und/oder eine bestimmte Zeit abgelaufen ist. Alternativ oder zusätzlich kann durch die elektrische Energiemenge eine entsprechende Schaltvorrichtung gesteuert werden und/oder ein Interrupt an der Steuervorrichtung ausgelöst werden. Vorteilhaft kann dadurch eine besonders energiesparende Betriebsweise der Mensch-Maschine-Schnittstelle realisiert werden.

Bei einer weiteren Ausführungsform des Verfahrens ist ein direktes Versorgen der Steuervorrichtung mit der elektrischen Energiemenge zum Ändern der visuellen Markierung und dadurch gleichzeitiges Wechseln des Betriebszustandes der Steuervorrichtung vorgesehen. Vorteilhaft kann dadurch die Mensch-Maschine-Schnittstelle hilfsenergielos und/oder energieautark betrieben werden. Es kann also vorteilhaft lediglich durch die Betätigung der Schaltfläche über den elektromechanischen Wandler so viel Energie gewonnen werden, dass dadurch die Steuervorrichtung und/oder die der Steuervorrichtung nachgeschaltete Anzeigevorrichtung elektrisch versorgt und infolgedessen das Ändern der visuellen Markierung durchgeführt werden kann. Vorteilhaft kann dadurch die Mensch-Maschine-Schnittstelle gänzlich ohne zusätzliche Energieversorgung betrieben werden.

Bei einer weiteren Ausführungsform des Verfahrens ist ein Steuern einer elektrischen Hilfsenergie, mittels der die Steuervorrichtung elektrisch versorgbar ist, in Abhängigkeit von der mittels des elektromechanischen Wandlers erzeugten elektrischen Energiemenge vorgesehen. Vorteilhaft kann die Steuervorrichtung mittels der elektrischen Hilfsenergiequelle elektrisch versorgt werden. Zum Einsparen der elektrischen Hilfsenergie ist es jedoch vorteilhaft möglich, die Energieversorgung, also die elektrische Hilfsenergiequelle von der Steuervorrichtung in Abhängigkeit von der elektrischen Energiemenge abzutrennen. Vorteilhaft kann die Steuerung so erfolgen, dass bei einem Vorhandensein der elektrischen Energiemenge zusätzlich die elektrische Hilfsenergiequelle der Steuervorrichtung zugeschaltet wird, sodass diese die durch das Vorhandensein der elektrischen Energiemenge ausgelöste Steuertätigkeit, also das Ändern der visuellen Markierung, ausführen kann. Sobald die elektrische Energiemenge nicht mehr zur Verfügung steh' und/oder eine gewisse Zeitspanne verstrichen ist, kann die elektrische Hilfsenergiequelle von der Steuervorrichtung getrennt werden, sodass ein minimaler Energieverbrauch möglich ist. Die Steuervorrichtung kann dadurch stromlos geschaltet werden. Vorteilhaft erfolgt dies während einer Zeit, in der keine Änderung der visuellen Markierung erforderlich ist, also solange die Mensch-Maschine-Schnittstelle, insbesondere die Schaltfläche nicht betätigt ist. Vorteilhaft kann während dieser unbetätigten Zeit elektrische Energie eingespart werden. Besonders vorteilhaft ist dies möglich, falls es sich bei der Anzeigevorrichtung um eine reflektive Anzeigevorrichtung handelt, insbesondere eine elektrophoretische Anzeige, eine bistabile LCD-Anzeige, eine mittels Elektrobenetzung realisierte Anzeige und/oder eine mikromechanisch gesteuerte Interferenzmodulationsanzeige oder ein elektronisches Papier im Allgemeinen. Vorteilhaft benötigen solche Anzeigevorrichtungen, falls keine Änderung eines aktuellen Anzeigeinhaltes durchgeführt wird, keinerlei elektrische Energie oder zumindest ein Minimum an elektrischer Energie. Alternativ oder zusätzlich kann bedarfsweise, insbesondere unabhängig von der Betätigungskraft, eine Beleuchtung der Anzeigevorrichtung vorgesehen sein, insbesondere die Anzeigevorrichtung als transreflektives Display ausgeführt sein.

Bei einer weiteren Ausführungsform des Verfahrens ist ein Auslösen eines Interrupts an der Steuervorrichtung in Abhängigkeit von der mittels des elektromechanischen Wandlers erzeugten elektrischen Energiemenge zum Wechseln des Betriebszustandes vorgesehen. Vorteilhaft kann mittels des Interrupts die Steuervorrichtung von dem energiesparenden Betriebszustand in den aktiven Betriebszustand gewechselt werden, wobei während des aktiven Betriebszustandes das Ändern der visuellen Markierung erfolgen kann. Alternativ oder zusätzlich ist es denkbar, dass in dem aktiven Betriebszustand die Steuervorrichtung mittels der elektrischen Hilfsenergiequelle und/oder der elektrischen Energiemenge gespeist wird. Sobald die elektrische Energiemenge nicht mehr vorhanden ist und/oder die visuelle Markierung geändert wurde und/oder eine gewisse Zeitspanne verstrichen ist, kann die Steuervorrichtung wieder in den energiesparenden Betriebszustand zurückgewechselt werden, sodass diese für den Interrupt zum erneuten Ändern der visuellen Markierung zur Verfügung steht.

Bei einer weiteren Ausführungsform des Verfahrens ist ein Steuern einer Vorrichtung in Abhängigkeit von der mittels des elektromechanischen Wandlers erzeugten elektrischen Energiemenge vorgesehen. Vorteilhaft kann mittels der Mensch-Maschine-Schnittstelle eine beliebige Vorrichtung, insbesondere ein elektrischer Verbraucher, gesteuert werden. Dabei kann es sich insbesondere um einen Türöffner, eine Klingel, eine Maschine, einen Fahrstuhl, eine Landmaschine, ein Flugzeug, ein Schiff und/oder Ähnliches handeln. Vorteilhaft kann die Vorrichtung in Abhängigkeit der Betätigungskraft gesteuert werden, wobei gleichzeitig durch das vorab beschriebene Ändern der visuellen Markierung eine betätigungsbedingte und/oder funktionsbedingte Rückmeldung an einen Bediener der Mensch-Maschine-Schnittstelle gegeben werden kann. Vorteilhaft kann diese Rückmeldung mittels der Anzeigevorrichtung auf reflektive Art und Weise erfolgen, sodass, sobald die visuelle Markierung geändert wurde, eine unabhängig von den Lichtverhältnissen gute Ablesbarkeit ähnlich wie mittels Farbpigmenten, insbesondere durch Bedrucken, herstellbare visuelle Markierungen, möglich ist. Vorteilhaft kann also eine gewohnte, an eine bedruckte Mensch-Maschine-Schnittstelle erinnernde Wertanmutung realisiert werden, wobei dennoch das Ändern der visuellen Markierung möglich ist.

Im Übrigen ergeben sich die vorab beschriebenen Vorteile der Mensch-Maschine-Schnittstelle.

Weitere Vorteile, Merkmale und Einzelheiten ergeben sich aus der nachfolgenden Beschreibung, in der - gegebenenfalls unter Bezug auf die Zeichnung - zumindest ein Ausführungsbeispiel im Einzelnen beschrieben ist. Beschriebene und/oder bildlich dargestellte Merkmale bilden für sich oder in beliebiger, sinnvoller Kombination den Gegenstand der Erfindung, gegebenenfalls auch unabhängig von den Ansprüchen, und können insbesondere zusätzlich auch Gegenstand einer oder mehrerer separaten Anmeldung/en sein. Gleiche, ähnliche und/oder funktionsgleiche Teile sind mit gleichen Bezugszeichen versehen.

Es zeigen:
- Fig. 1: eine Draufsicht auf eine schematisiert dargestellte Mensch-Maschine-Schnittstelle mit einer Vielzahl von manuell betätigbaren Schaltflächen;
- Fig. 2: eine schematische Detailansicht eines Schnitts durch eine der Schaltflächen der in Fig. 1 dargestellten Mensch-Maschine-Schnittstelle in einer Explosionsdarstellung;
- Fig. 3: ein Blockschaltbild einer weiteren Mensch-Maschine-Schnittstelle mit einer Hilfsenergiequelle;
- Fig. 4: ein Blockschaltbild einer Mensch-Maschine-Schnittstelle analog der in Fig. 3 dargestellten, wobei im Unterschied die Hilfsenergiequelle schaltbar ist; und
- Fig. 5: ein Blockschaltbild einer weiteren Mensch-Maschine-Schnittstelle mit einer Vielzahl von drei Schaltflächen.

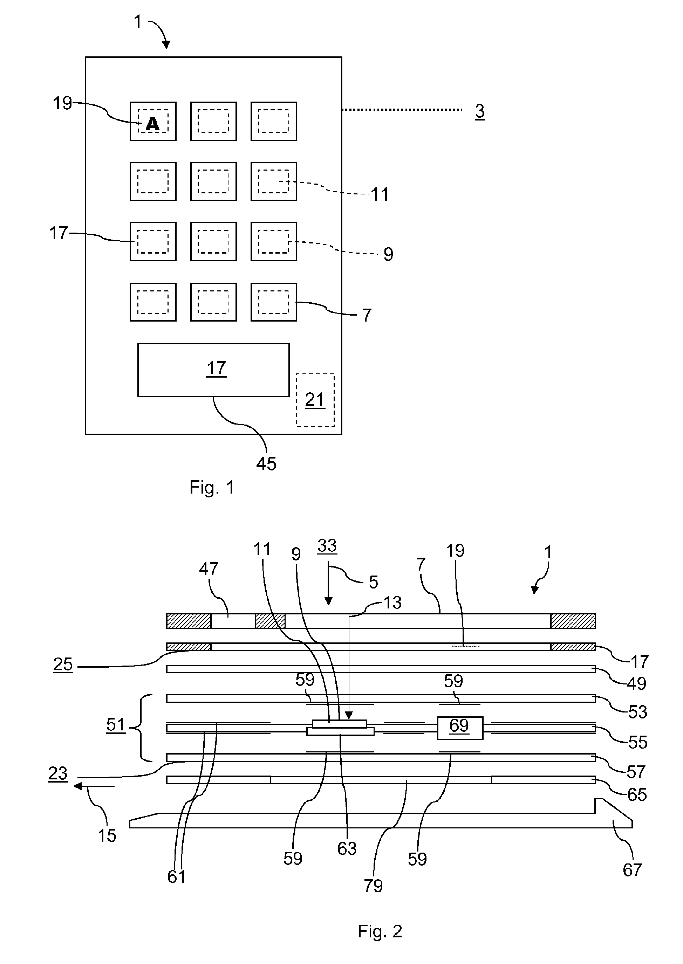

Fig. 1 zeigt eine Mensch-Maschine-Schnittstelle 1 zum Steuern einer in Fig. 1 lediglich mittels des Bezugszeichens 3 angedeuteten Vorrichtung. Bei der Vorrichtung 3 kann es sich um eine beliebige Maschine, insbesondere einen elektrischen Verbraucher, insbesondere ein Landfahrzeug, ein Flugzeug, ein Wasserfahrzeug, ein Produktionsmittel, Haustechnik und/oder Ähnliches, handeln. Die Mensch-Maschine-Schnittstelle 1 weist eine Vielzahl von Schaltflächen 7 auf, die mittels einer nicht näher dargestellten Betätigungskraft, insbesondere manuell aufbringbar, betätigbar sind. Unter den Schaltflächen 7, insbesondere direkt benachbart zu den Schaltflächen 7 ist jeweils ein elektromechanischer Wandler 9 vorgesehen. Die elektromechanischen Wandler 9 sind mittels gestrichelten Umrissen dargestellt. Jeder der elektromechanischen Wandler 9 weist ein piezoelektrisches Element 11 auf, das in Fig. 1 nicht näher dargestellt ist. Die elektromechanischen Wandler 9 sind fest mit einer Steuervorrichtung 21 verdrahtet. Die Steuervorrichtung 21 ist gemäß der Darstellung in Fig. 1 Teil der Mensch-Maschine-Schnittstelle 1. Alternativ oder zusätzlich ist es jedoch auch möglich, die Steuervorrichtung 21 separat, also getrennt von der Mensch-Maschine-Schnittstelle 1 vorzusehen. Gegebenenfalls kann eine elektrische Verbindung über entsprechende Kabel hergestellt werden.

Den Schaltflächen 7 ist eine Anzeigevorrichtung 17 zugeordnet. Mittels der Anzeigevorrichtung 17 kann jede der Schaltflächen 7 mit einer visuellen Markierung 19 versehen werden. Unter einer visuellen Markierung 19 kann eine beliebige optische Darstellung, insbesondere eine Farbe, ein Symbol, eine Ziffer und/oder ein Buchstabe und/oder Ähnliches verstanden werden. Die Anzeigevorrichtung 17 ist vorteilhaft frei programmierbar, sodass jede der Schaltflächen 7 eine beliebige visuelle Markierung aufweisen kann. Gemäß einer vorteilhaften Alternative ist die Anzeigevorrichtung 17 derartig vergrößert, dass auf einer separaten Anzeigefläche 45 eine zusätzliche Darstellung erfolgen kann. Insbesondere können auf der zusätzlichen Anzeigefläche 45 Informationen wiedergegeben werden. Insbesondere kann es sich dabei um Mitteilungen und/oder Bedienungshinweise für einen Benutzer der Mensch-Maschine-Schnittstelle 1 handeln. Alternativ oder zusätzlich können über die zusätzliche Anzeigefläche 45 auch, insbesondere zusätzliche, funktions- und/oder betätigungsabhängige Rückmeldungen gegeben werden.

Fig. 2 zeigt ein Detail einer der in Fig. 1 gezeigten Schaltflächen 7 mit der jeweils darunter liegenden Anzeigevorrichtung 17 und einem der elektromechanischen Wandler 9 in einer Schnittansicht in einer Explosionsdarstellung. Die in Fig. 2 dargestellte Mensch-Maschine-Schnittstelle 1 weist eine Vielzahl von Schichten auf. Einer die Mensch-Maschine-Schnittstelle 1 benutzenden Person zugewandte Oberseite weist eine Overlayschicht 47 auf. Die Overlayschicht 47 ist zumindest bereichsweise transparent ausgebildet und dient insbesondere als mechanischer Schutz für die darunter liegenden Schichten und Funktionselemente der Mensch-Maschine-Schnittstelle 1. Auf einer der Person 33 abgewandten Unterseite der Overlayschicht 47 weist diese eine Kaschierung und/oder eine Bedruckung auf, die ein optisches Erscheinungsbild und/oder eine Wertanmutung der Mensch-Maschine-Schnittstelle 1 bewirkt. Insbesondere ist die Kaschierung und/oder Bedruckung nicht lichtdurchlässig und schirmt eine benachbart zu der Overlayschicht 47 angeordnete Anzeigevorrichtung 17 optisch in Richtung der Person 33 ab. Benachbart zu der Overlayschicht 47 ist die Anzeigevorrichtung 17 angeordnet. Die Anzeigevorrichtung 17 und die Overlayschicht 47 können mechanisch miteinander verbunden sein, insbesondere mittels eines in Fig. 2 nicht dargestellten transparenten Klebers. Die Anzeigevorrichtung 17 dient zum Darstellen der visuellen Markierung 19, die in Fig. 2 mittels einer gepunkteten Linie symbolisiert ist. Die visuelle Markierung 19 ist durch die Overlayschicht 47 hindurch optisch beim Betrachten der Mensch-Maschine-Schnittstelle 1 wahrnehmbar.

Benachbart zu der Anzeigevorrichtung 17 ist eine Overlay-Kleberschicht 49 angeordnet. Die Overlay-Kleberschicht 49 kann einen beliebigen Kleber aufweisen. Insbesondere weist die Overlay-Kleberschicht 49 vorzugsweise ein Substrat, insbesondere eine Folie, auf, die beidseitig mit einer Klebeschicht, insbesondere einer Selbstklebeschicht, versehen ist. Alternativ kann auf das Substrat verzichtet werde und lediglich eine Schicht eines transparenten Klebers vorgesehen sein. Vorteilhaft kann dadurch die Overlay-Kleberschicht 49 mit der Anzeigevorrichtung 17, insbesondere vollflächig, verklebt werden. Benachbart zu der Overlay-Kleberschicht 49 ist ein Piezoschaltpaket 51 angeordnet, das mittels einer geschwungenen Klammer in Fig. 2 gekennzeichnet ist und insgesamt drei Schichten aufweist. Mittels der Overlay-Kleberschicht 49 kann das Piezoschaltpaket 51, insbesondere vollflächig, mit dieser und dadurch mit der Anzeigevorrichtung 17 verklebt werden.

Das Piezoschaltpaket 51 weist eine obere Leiterschicht 53, eine Beabstandungsschicht 55 und eine untere Leiterschicht 57 auf. Die Leiterschichten 53 und 57 weisen jeweils Leiterbahnen 59 auf. Die Beabstandungsschicht 55 weist ein Substrat auf, das beidseitig eine Selbstklebeschicht 61 aufweist. Über die Selbstklebeschichten 61 der Beabstandungsschicht 55 können die Leiterschichten 53 und 57 miteinander verbunden werden, insbesondere jeweils vollflächig mit der Beabstandungsschicht 55 verklebt werden. Ein vorteilhaftes Piezoschaltpaket 51 ist in der DE 693 04 443 T2 beschrieben, deren Offenbarung bezüglich des Aufbaus des Piezoschaltpakets 51, insbesondere die Figuren, deren Beschreibung sowie die Ansprüche, hiermit durch Bezugnahme zum Inhalt dieser Anmeldung gemacht wird. Alternativ oder zusätzlich ist es denkbar, andere Arten von von druck- / verformungsempfindlichen Sensoren, z.B. piezoresistive Sensoren oder ein Force Sensing Resistor (FSR) vorzusehen.

In der Beabstandungsschicht 55 sind zwei Ausnehmungen vorgesehen, wobei in eine erste Ausnehmung ein piezoelektrisches Element 11 und ein elektrisch leitender Träger 63 eingelassen sind. Der leitende Träger 63 ist elektrisch und mechanisch mit dem piezoelektrischen Element 11 verbunden. Zum Herstellen eines Kraftschlusses zwischen dem piezoelektrischen Element 11 und der oberen Leiterschicht 53 und damit zwischen den dem piezoelektrischen Element 11 und der Schaltfläche 7 liegenden Schichten der Mensch-Maschine-Schnittstelle 1, können das piezoelektrischen Element 11 und der leitende Träger 63 zusammen eine zumindest geringfügig größere Dicke aufweisen als die Beabstandungsschicht 55.

Die Leiterbahnen 59 dienen zum Ableiten einer elektrischen Energiemenge 15, die mittels des piezoelektrische Elements 11 erzeugbar ist in Richtung eines in Fig. 2 lediglich mittels des Bezugszeichens 23 symbolisierten Mikrocontrollers oder anderen Steuer- und/oder Schaltelektronik.

Benachbart zu der unteren Leiterschicht 57 des Piezoschaltpakets 51 ist eine Basiskleberschicht 65 angeordnet. Diese weist analog der Overlay-Kleberschicht 48 ein Substrat auf, das beidseitig mit einer Klebeschicht, insbesondere einer Selbstklebeschicht versehen ist. Benachbart zu der Basiskleberschicht 65 ist ein Gehäuse 67 der Mensch-Maschine-Schnittstelle 1 angeordnet oder zumindest anordenbar. Mittels der Basiskleberschicht 65 können die übrigen Schichten der Mensch-Maschine-Schnittstelle 1 mit dem Gehäuse 67 verbunden, insgesamt vollflächig verklebt, werden.

Im Folgenden wird näher auf die Funktion der Mensch-Maschine-Schnittstelle 1, insbesondere des Piezoschaltpakets 51 eingegangen. Eine Betätigung der Schaltfläche 7 durch die Person 33 durch Ausüben einer Betätigungskraft 5 auf die Schaltfläche 7 bewirkt, das Einleiten einer mechanischen Energiemenge 13 in die Mensch-Maschine-Schnittstelle 1. Die Betätigungskraft 5 bewirkt dadurch eine elastische Verformung der Overlayschicht 47 und der benachbart dazu angeordneten Anzeigevorrichtung 17. Vorteilhaft kann die Anzeigevorrichtung 17 reversibel elastisch verformbar sein, also elastische Eigenschaften aufweisen. Vorteilhaft ist die Anzeigevorrichtung 17 so zwischen der Overlayschicht 47 und dem Piezoschaltpaket 51 bzw. der Overlay-Kleberschicht 49 angeordnet, dass die elastische Verformung der Anzeigevorrichtung 17 auf das Piezoschaltpaket 51 und dadurch auf den leitenden Träger 63 und auf das piezoelektrische Element 11 weitergeleitet wird. Dadurch erfolgt eine Verformung des piezoelektrischen Elements 11. Diese Verformung des piezoelektrische Elements 11 bewirkt eine Wandlung der mechanischen Energiemenge 13 in die elektrische Energiemenge 15. Diese wird wie vorab beschrieben über die Leiterbahnen 59 der Leiterschichten 53 und 57 abgeleitet. Dazu weist die Beabstandungsschicht 55 eine weitere Ausnehmung auf, in die ein Kontaktelement 69 eingelassen ist. Das Kontaktelement 69 dient zum elektrischen Kontaktieren der Leiterbahn 59, der oberen Leiterschicht 53 und der unteren Leiterschicht 57.

Über die Leiterbahn 59 und das Kontaktelement 69 wird infolge der Betätigungskraft 5 die elektrische Energiemenge 15 schließlich zu dem Mikrocontroller 23 oder anderen Steuer-/ Schaltelektronik weitergeleitet.

Vorteilhaft kann in Abhängigkeit der elektrischen Energiemenge 15 mittels einer Anzeigesteuerung, die in Fig. 2 lediglich mittels des Bezugszeichens 25 angedeutet ist, die visuelle Markierung 19 geändert werden. Dazu steuert eine Steuerelektronik, hier der Mikrocontroller 23, die Anzeigesteuerung 25, die wiederum die Anzeigevorrichtung 17 zum Ändern der visuellen Markierung 19 steuert. Dadurch kann vorteilhaft durch die Betätigungskraft 5 ein Ändern der visuellen Markierung 19 bewirkt werden. Außerdem kann mittels des Mikrocontrollers 23 die Vorrichtung 3 in Abhängigkeit der auf die Schaltfläche 7 wirkenden Betätigungskraft 5 gesteuert werden.

Der leitende Träger 63 weist außerdem elektrisch leitende Eigenschaften auf und dient neben einem Zwischenspeichern der mechanischen Energiemenge 13 auch zum Weiterleiten der elektrischen Energiemenge 15 in die Leiterbahnen 59 der unteren Leiterschicht 57.

Die Basiskleberschicht 65 weist insbesondere eine Ausnehmung 79 auf. Die Ausnehmung 79 ist im Bereich bzw. benachbart zu dem piezoelektrischen Element 11 angeordnet. Vorteilhaft kann dadurch der leitende Träger 63 bei einer Verformung in die Ausnehmung 79 hineinragen. Vorteilhaft kann so die mechanische Energiemenge 13 mit einem höheren Wirkungsgrad auf das piezoelektrische Element 11 übertragen werden. Alternativ oder zusätzlich kann anstelle der Ausnehmung 79 an der Basiskleberschicht 65 ein elastisch zurückweichendes Material verwendet werden und/oder diese kann ein solches aufweisen, sodass ebenfalls der leitende Träger 63 bei einer Verformung in diese Richtung ausweichen kann.

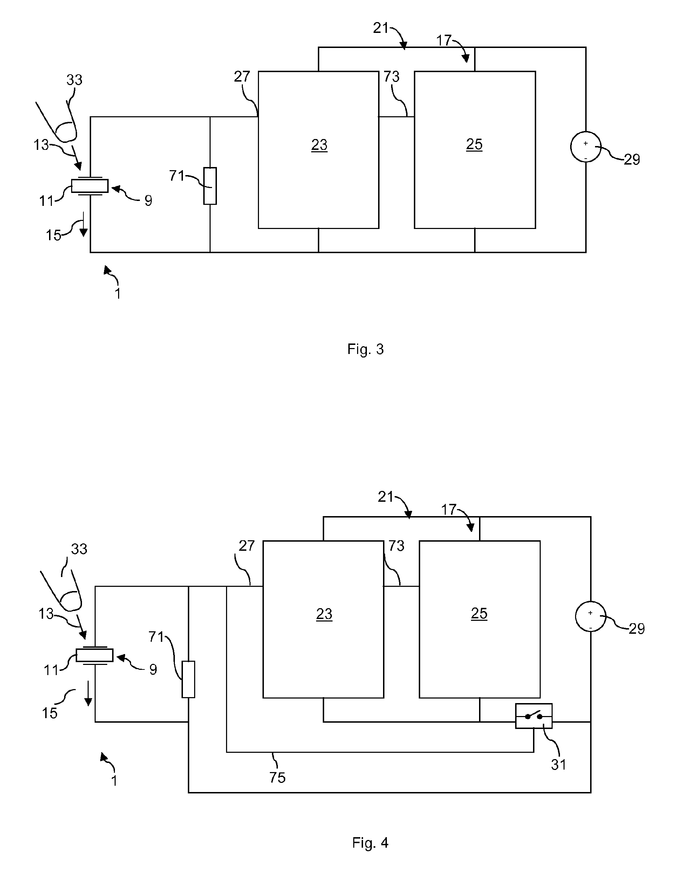

Fig. 3 zeigt ein Blockschaltbild einer weiteren Mensch-Maschine-Schnittstelle 1. Die in Fig. 3 gezeigte Mensch-Maschine-Schnittstelle 1 wird mittels einer Hilfsenergiequelle 29 elektrisch versorgt. In Fig. 3 ist die Person 33 nur teilweise dargestellt. Außerdem ist mittels eines Pfeils die mechanische Energiemenge 13 symbolisiert, die mittels einer Betätigung durch die Person 33 über die Schaltfläche 7 in die Mensch-Maschine-Schnittstelle 1 einbringbar ist. Diese kann mittels des piezoelektrische Elements 11 in die elektrische Energiemenge 15 gewandelt werden.

Parallel zu dem piezoelektrischen Element 11 ist ein Widerstand und/oder Kondensator 71 geschaltet. Der Widerstand 71 erhöht vorteilhaft eine elektromagnetische Verträglichkeit der Mensch-Maschine-Schnittstelle 1 und/oder bewirkt eine Reduktion von möglichen Fehlauslösungen und/oder legt den elektrischen Zustand im Ruhezustand (kein Tastendruck) fest. Vorteilhaft können über den Widerstand 71 schwache Ladungen abgeführt werden, wobei dadurch vorteilhaft mögliche Fehlauslösungen vermeiden werden können. Das piezoelektrische Element 11 weist zwei elektrische Anschlüsse auf, wobei einer der Anschlüsse an /einen Interrupteingang 27 des Mikrocontrollers 23 der Mensch-Maschine-Schnittstelle 1 angeschlossen ist.

Der Mikrocontroller 23 wird von der Hilfsenergiequelle 29 mit einer positiven und einer negativen Spannung elektrisch versorgt. Die Anzeigevorrichtung 17 wird ebenfalls mittels der elektrischen Hilfsenergiequelle 29 elektrisch versorgt.

Eine Betätigung des piezoelektrischen Elements 11 bewirkt über den Interrupteingang 27 ein Interrupt des Mikrocontrollers 23. Dadurch kann der Mikrocontroller 23 von einem energiesparenden Betriebszustand in einen aktiven Betriebszustand gebracht werden. In dem aktiven Betriebszustand verbraucht der Mikrocontroller 23 mehr von der Hilfsenergiequelle 29 gelieferte elektrische Energie, die dazu verwendet wird, über eine Datenstrecke 73 die Anzeigesteuerung 25 derartig anzusteuern, dass diese die in Fig. 3 nicht näher dargestellte Anzeigevorrichtung 17 so ansteuert bzw. verändert, dass die visuelle Markierung 19 der Schaltfläche 7 der Mensch-Maschine-Schnittstelle 1 geändert wird. Der Mikrocontroller 23 und die Anzeigesteuerung 25 sind über die Datenstrecke 73 datentechnisch miteinander verbunden.

Fig. 4 zeigt ein Blockschaltbild einer weiteren Mensch-Maschine-Schnittstelle 1 analog der in Fig. 3 dargestellten Mensch-Maschine-Schnittstelle 1. Im Folgenden wird lediglich auf die Unterschiede eingegangen. Im Unterschied zur Darstellung gemäß der Fig.. 3 ist die Hilfsenergiequelle 29 nicht direkt an den Mikrocontroller 23 und die Anzeigesteuerung 25 angeschlossen. Vielmehr ist zumindest ein Ausgang der Hilfsenergiequelle 29 an eine Schaltvorrichtung 31 angeschlossen. Dieser Ausgang ist also über die Schaltvorrichtung 31 an den Mikrocontroller 23 und die Anzeigesteuerung 25 angeschlossen. Die Schaltvorrichtung 31 ist über eine Steuerleitung 75 an zumindest einen Ausgang des piezoelektrischen Elements 11 angeschlossen. Über die Steuerleitung 75 kann die Schaltvorrichtung 31 einen Teil der elektrischen Energiemenge 15 aufnehmen und als Steuersignal verarbeiten. Vorteilhaft kann, sobald die elektrische Energiemenge 15 vorhanden ist, die Schaltvorrichtung 31 leitend geschaltet werden, sodass danach wie vorab beschrieben die Änderung der visuellen Markierung 19 möglich ist. Sobald die elektrische Energiemenge 15 nicht mehr über die Steuerleitung 75 an dem Eingang der Schaltvorrichtung 31 anliegt, ändert diese ihren Schaltzustand in nicht leitend, sodass dadurch vorteilhaft die Hilfsenergiequelle 29 von dem Mikrocontroller 23 und der Anzeigesteuerung 25 abgetrennt ist. Vorteilhaft kann dadurch der Stromverbrauch des Mikrocontrollers 23 und der Anzeigesteuerung 25 quasi auf null reduziert werden. Alternativ oder zusätzlich kann der Schaltvorgang der Schaltvorrichtung 31 nach Ablauf einer Zeitspanne erfolgen, insbesondere sobald die visuelle Markierung 19 geändert ist.

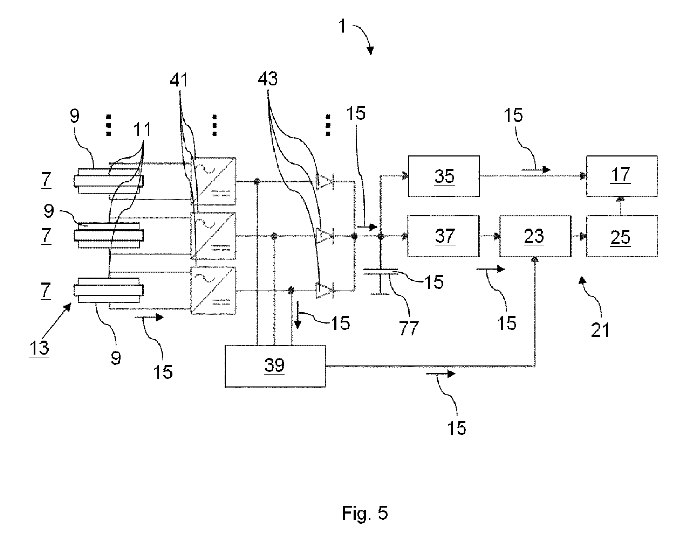

Fig. 5 zeigt ein Blockschaltbild einer weiteren Mensch-Maschine-Schnittstelle 1 analog der vorab beschriebenen. Im Folgenden wird lediglich auf die Unterschiede eingegangen.

Die in Fig. 5 dargestellte Mensch-Maschine-Schnittstelle 1 weist insgesamt drei der Schaltflächen 7 auf, wobei den Schaltflächen 7 jeweils ein piezoelektrisches Element 11 des jeweiligen elektromechanischen Wandlers 9 nachgeschaltet ist. Mittels Punkten ist in Fig. 5 symbolisiert, das je nach Anwendung zumindest ein piezoelektrisches Element 11 vorgesehen ist, also gegebenenfalls mehr oder weniger als die dargestellten drei. Jeder der elektromechanischen Wandler 9 weist zwei Ausgänge auf, die jeweils an einen Gleichrichter 41, insbesondere Brückengleichrichter, angeschlossen sind. Als Ausgang liefern die Gleichrichter 41 jeweils eine Gleichspannung, die jeweils über eine Diode 43 an einem ersten Spannungsregler 35 und einem zweiten Spannungsregler 37 anliegen bzw. angeschlossen sind.

Außerdem ist jedem der Gleichrichter 41 ein Eingang eines Identifizierers 39 nachgeschaltet. Der Identifizierer 39 dient dazu festzustellen, an welchem der elektromechanischen Wandler 9 eine der elektrischen Energiemengen 15 bereitgestellt wird. Die piezoelektrischen Elemente 11 sind also logisch fest verdrahtet.

In einem Parallelzweig ist den Dioden 43 nachgeschaltet bzw. den Spannungsreglern 35 und 37 vorgeschaltet eine Kapazität 77 vorgesehen. Die Kapazität 77 dient zum kurzzeitigen Zwischenspeichern der elektrischen Energiemenge 15.

Der erste Spannungsregler 35 liefert ein erstes Spannungsniveau, das an einen Bedarf der Anzeigevorrichtung 17 angepasst ist. Der zweite Spannungsregler 37 liefert ein zweites Spannungsniveau, das an einen Bedarf des Mikrocontrollers 23 angepasst ist. Insbesondere weist die Anzeigevorrichtung 17 üblicherweise eine höhere Arbeitsspannung auf als der Mikrocontroller 23, was vorteilhaft mittels der zwei Spannungsregler 35 und 37 eingestellt bzw. bereitgestellt werden kann.

Dazu ist die Anzeigevorrichtung 17 dem ersten Spannungsregler 35 nachgeschaltet und der Mikrocontroller 23 der Stellvorrichtung 21 dem zweiten Spannungsregler 37.

Wie aus Fig. 5 ersichtlich, weist die Steuervorrichtung 21 den Mikrocontroller 23 und die Anzeigesteuerung 25 auf. Wie vorab beschrieben, steuert der Mikrocontroller 23 die Anzeigesteuerung 25 und diese die eigentliche Anzeigevorrichtung 17, wie sie in Fig. 2 dargestellt ist.

Zusammenfassend ist es vorteilhaft möglich, aus jedem Tastendruck bzw. Betätigen einer der Schaltflächen 7 die elektrische Energiemenge 15 zur Veränderung der visuellen Markierung 19 auf der Anzeigevorrichtung 17 zu gewinnen. Vorteilhaft kann jede Betätigung grafisch mittels der visuellen Markierung 19 auf der Anzeigevorrichtung 17 bestätigt werden. Alternativ oder zusätzlich ist es denkbar, funktionsbedingt einen Fortschritt oder das Resultat einer durch die Betätigung der Schaltfläche 7 ausgelösten Funktion, insbesondere die Steuerung der Vorrichtung 3 auf der Anzeigevorrichtung 17, insbesondere der in Fig. 1 gezeigten zusätzlichen Anzeigefläche 45 anzuzeigen. Alternativ oder zusätzlich sind Mehrfachbelegungen der Schaltflächen 7, also das Zuordnen mehrerer Funktionen pro Schaltfläche 7 möglich, wobei vorteilhaft dazu unterschiedliche visuelle Markierungen 19 vorgesehen sein können.

Jeder der Schaltflächen 7 und/oder über die weitere Anzeigefläche 45 kann eine visuelle Markierung 19 als Zustandsanzeige einer entsprechenden Funktion der jeweiligen Schaltfläche 7 erfolgen, insbesondere können Informationen oder Sätze ausgegeben werden, wie beispielsweise 'Willkommen', 'Tür entriegelt', 'Bitte nicht stören', Stockwerksanzeigen für einen Fahrstuhl und/oder Ähnliches. Insbesondere für Fahrstühle kann alternativ zwischen einer Anzeige von Stockwerken und/oder sich dort befindlichen Räumlichkeiten und/oder Ähnlichem gewählt werden. Vorteilhaft kann dadurch eine dynamische Bedienerführung der die Mensch-Maschine-Schnittstelle 1 bedienenden Person 33 realisiert werden.

Alternativ oder zusätzlich ist es denkbar, die Steuervorrichtung 21 über ein Netzwerk mit einem von der Person 33 bedienbaren mobilen Endgerät, insbesondere ein Funknetzwerk, zu verbinden, sodass Informationen zum Darstellen über die visuelle Markierung 19 hinterlegt werden können. Insbesondere ist es denkbar, für Klingelfelder an Wohngebäuden über eine mobile Anwendung seinen eigenen Namen an einer entsprechenden Türklingel, die mittels einer der Schaltflächen 7 realisiert ist, zu hinterlegen.

Alternativ oder zusätzlich kann die Overlayschicht 47 als Dekorfront dienen, insbesondere zu diesem Zweck die Kaschierungen und/oder rückseitigen Bedruckungen aufweisen. Vorteilhaft kann mittels der Overlayschicht 47 ein Schutz gegen Missbrauch und/oder Vandalismus hergestellt werden. Alternativ oder zusätzlich kann auch ein Schutz gegen eindringendes Wasser realisiert werden.

Vorteilhaft ist das Aufbringen der Betätigungskraft 5 mit beliebigen Gegenständen möglich, sodass es der Person 33 möglich ist, die Mensch-Maschine-Schnittstelle 1 insbesondere auch mit Handschuhen, nassen Fingern und/oder Hilfsmitteln, insbesondere Kugelschreiber und/oder Ähnliches, zu bedienen, insbesondere auch wenn die Schaltfläche 7 durch eine Flüssigkeit benetzt ist. Vorteilhaft ist dies im Vergleich zu kapazitiven berührungsempfindlichen Bildschirmen möglich.

Vorteilhaft kann die Mensch-Maschine-Schnittstelle 1, während sie nicht bedient wird, in den energiesparenden Betriebszustand gebracht werden. Vorteilhaft kann das Aufwecken mittels der elektrischen Energiemenge 15, insbesondere über den Interrupteingang 27 des Mikrocontrollers 23 und/oder das Schalten der Schaltvorrichtung 31 erfolgen. Vorteilhaft kann die Steuervorrichtung 21 in dem energiesparenden Betriebszustand stromlos oder zumindest im Wesentlichen stromlos sein. Vorteilhaft kann die Anzeigevorrichtung 17 so ausgelegt sein, dass diese im Ruhezustand, also ohne eine Änderung der visuellen Markierung 19 gänzlich ohne Energiezufuhr auskommt. Vorteilhaft kann dadurch eine besonders energiesparende Mensch-Maschine-Schnittstelle 1 bereitgestellt werden.

Optional ist es denkbar, die Hilfsenergiequelle 29 als Solarzelle, einem thermoelektrischen Generator oder andere sog. "Energy Harvesting"-Energiequellen vorzusehen. Alternativ oder zusätzlich kann die Hilfsenergiequelle 29 jedoch auch einen Anschluss an ein Stromnetz und/oder eine Batterie aufweisen.

Optional ist es denkbar, dass die elektromechanischen Wandler und die enthaltenen piezoelektrischen Elemente 11 durch das Wandeln der mechanischen Energiemenge 13 die gesamte Steuervorrichtung 21 und vorteilhaft insbesodere auch die Anzeigevorrichtung elektrisch versorgen. Dadurch ist ein gänzlich energieautarkes System, also eine gänzlich energieautarke Mensch-Maschine-Schnittstelle 1, möglich. Vorteilhaft können aufwändige Verkabelungen der sonst erforderlichen elektrischen Versorgung bzw. Stromversorgung eingespart werden.

Alternativ oder zusätzlich ist es denkbar, dass die Steuervorrichtung 21 unterhalb bzw. benachbart von der der Person 33 abgewandten Seite des Piezoschaltpakets 51 angeordnet ist. Gegebenenfalls kann die Steuervorrichtung 21 als Leiterplatte mit der Basiskleberschicht 65 verklebt werden und/oder als Teil des Gehäuses 67 vorgesehen sein und/oder als zusätzliche Schicht zwischen dem Gehäuse 67 und der Basiskleberschicht 65 angeordnet sein.

Die Mensch-Maschine-Schnittstelle 1 benötigt, während die Person 33 keine Aktivität vornimmt, vorteilhaft keine oder zumindest nur eine geringe Menge an elektrischer Energie. Dies kann vorteilhaft durch den Interrupt des Mikrocontrollers 23 und/oder die Schaltvorrichtung 31 sichergestellt werden. Mittels der Schaltvorrichtung 31 kann vorteilhaft ein möglicherweise vorhandener Leckstrom des Mikrocontrollers 23 zusätzlich eliminiert werden. Durch die Betätigungskraft 5 auf die Schaltfläche 7 erzeugt das piezoelektrische Element 11 ein Spannungssignal bzw. die elektrische Energiemenge 15, die vorteilhaft groß genug ist, den Mikrocontroller 23 über den Interrupteingang 27 zu wecken. Dieser führt dann zum Ändern der visuellen Markierung 19 und/oder zur Steuerung der Vorrichtung 3 notwendige Aktionen aus, insbesondere das Betätigen einer Türklingel, das Messen einer Temperatur und/oder Ähnliches und schickt als funktionale und/oder Betätigungsrückmeldung entsprechende Bilddaten zu der Anzeigevorrichtung 17 zum Ändern der visuellen Markierung 19. Vorteilhaft kann dies auf eine vergleichsweise kurze Zeitdauer begrenzt werden, sodass danach sofort wieder in den energiesparenden Betriebszustand gewechselt werden kann.

Der in den Fig. 3 und 4 dargestellte, dem piezoelektrischen Element 11 parallel geschaltete Widerstand 71 stellt sicher, dass kein falsches Wecksignal erzeugt wird. Alternativ oder zusätzlich ist es denkbar, den Mikrocontroller 23 so auszustatten, einzurichten und/oder zu programmieren bzw. mit einer Logik zu versehen, dass falsche Auslösungen an einem der elektromechanischen Wandler 9 erkannt und entsprechend unterdrückt werden können. Insbesondere kann dazu ermittelt werden, dass das Eingangssignal an dem Interrupteingang 27 eine gewisse Mindestdauer aktiv ist. Bei einer elektromagnetischen Verträglichkeitsstörung wäre dies beispielsweise nur sehr kurz.

Bei der in Fig. 5 dargestellten Variante ist vorteilhaft keine Hilfsenergiequelle 29 erforderlich. Sofern die Person 33 keine Aktivität an der Mensch-Maschine-Schnittstelle 1 vornimmt, bleiben sämtliche visuellen Markierungen 19 auch im komplett stromlosen Zustand erhalten. Sofern einer der elektromechanischen Wandler 9 betätigt wird, wird der Spannungsimpuls bzw. die dadurch erzeugte elektrische Energiemenge 15 genutzt und vorteilhaft zusätzlich daraus erkannt, welcher der elektromechanischen Wandler 9, also welche der Schaltflächen 7 gedrückt wurde. Vorteilhaft kann dann je nach betätigter Schaltfläche 7 eine zugeordnete bzw. gewünschte Aktion bzw. Steuerung der Vorrichtung 3 durchgeführt werden und gegebenenfalls die entsprechende visuelle Markierung 19 verändert werden.

Dazu wird der Spannungsimpuls des piezoelektrischen Elements 11, der als Wechselspannung auftritt, zunächst über die Gleichrichter 41 bzw. einen der Gleichrichter 41, gleichgerichtet. Die den Gleichrichtern 41 nachgeschalteten Dioden 43 stellen sicher, dass die an einem der piezoelektrischen Elemente 11 erzeugte elektrische Energiemenge nicht in benachbarte piezoelektrische Elemente 11 zurückfließt und dadurch verloren geht. Vorteilhaft erzeugen die piezoelektrischen Elemente 11 eine vergleichsweise hohe Spannung, die mittels der Spannungsregler 35 und 37 an die Anzeigevorrichtung 17 und den Mikrocontroller 23 angepasst werden können. Nach der durchgeführten Steuerung der Vorrichtung 3 und/oder dem Ändern der visuellen Markierung 19 wird die noch im System verbliebene restliche elektrische Energiemenge 15 vernichtet und die Mensch-Maschine-Schnittstelle 1 geht in den stromlosen Zustand zurück. Die Anzeigevorrichtung 17 kann mit einer Spannung zwischen 1 - 20 V, insbesondere 5 - 20 V, insbesondere 10 - 18 V, insbesondere 12 - 17 V betrieben werden, sowie allenfalls mit negativen Spannungen bis -20 V. Der Mikrocontroller 23 bzw. die Steuervorrichtung 21 kann mit einer Spannung zwischen 1 - 5 V, insbesondere 2 - 5 V, insbesondere 3 - 4,5 V, insbesondere ungefähr 4 V, betrieben werden. Vorteilhaft können diese Spannungen mittels der Spannungsregler 35 und 37 eingestellt werden.

Vorteilhaft kann die vorab beschriebene Mensch-Maschine-Schnittstelle 1 auch für Anwendungen konzipiert werden, bei denen es auf eine hohe Energieeffizienz und eine flache, von der Person 33 optisch und haptisch wahrnehmbare Bedienoberfläche ankommt, also die Schaltflächen 7 bündig zur übrigen Bedienoberfläche angeordnet sind. Insbesondere kann in einem solchen Fall die Anzeigevorrichtung komplett passiv ausgelegt sein, insbesondere die visuelle Markierung auf herkömmliche Art und Weise beispielsweise mittels Farbe oder Bedruckungen darstellen. In diesem Fall kann also die visuelle Markierung zwar nicht in Abhängigkeit der erzeugten elektrischen Energiemenge 13 geändert werden, es können jedoch die oben beschriebene vorteilhafte Energieeinsparung realisiert werden. Es ist also eine energiesparende Mensch-Maschine-Schnittstelle 1 mit einer hohen Wertanmutung möglich, die durch einfaches Berühren sicher bedienbar ist. Insbesondere kann dazu der zu den Figuren 3, 4 und/oder 5 beschriebene Aufbau verwendet werden, wobei die Anzeigesteuerung 25 entfällt, also lediglich, insbesondere über den Mikrocontroller 23, die in den Figuren 3, 4 und/oder 5 nicht näher dargestellte Vorrichtung 3 auf stromsparende Art und Weise angesteuert wird. Insbesondere Anwendungen in der Haustechnik sind damit vorteilhaft darstellbar.

### Bezugszeichenliste

- 1: Mensch-Maschine-Schnittstelle
- 3: Vorrichtung
- 5: Betätigungskraft
- 7: Schaltfläche
- 9: elektromechanischer Wandler
- 11: piezoelektrisches Element
- 13: mechanische Energiemenge
- 15: elektrische Energiemenge
- 17: Anzeigevorrichtung
- 19: visuelle Markierung
- 21: Steuervorrichtung
- 23: Mikrocontroller
- 25: Anzeigesteuerung
- 27: Interrupteingang
- 29: Hilfsenergiequelle
- 31: Schaltvorrichtung
- 33: Person
- 35: erster Spannungsregler
- 37: zweiter Spannungsregler
- 39: Identifizierer
- 41: Gleichrichter
- 43: Diode
- 45: Anzeigefläche
- 47: Overlayschicht
- 49: Overlay-Kleberschicht
- 51: Piezoschaltpaket
- 53: obere Leiterschicht
- 55: Beabstandungsschicht
- 57: untere Leiterschicht
- 59: Leiterbahnen
- 61: Selbstklebeschicht
- 63: leitender Träger
- 65: Basiskleberschicht
- 67: Gehäuse
- 69: Kontaktelement
- 71: Widerstand
- 73: Datenstrecke
- 75: Steuerleitung
- 77: Kapazität
- 79: Ausnehmung

## Patentansprüche

1. Mensch-Maschine-Schnittstelle (1) zum Steuern einer Vorrichtung (3), mit:
- einer durch eine Betätigungskraft (5) betätigbaren Schaltfläche (7),
- einem zumindest während eines Einwirkens der Betätigungskraft (5) mit der Schaltfläche (7) mechanisch gekoppelten elektromechanischen Wandler (9) zum Wandeln einer durch die Betätigungskraft (5) bewirkbaren mechanischen Energiemenge (13) in eine elektrische Energiemenge (15),
- einer Anzeigevorrichtung (17), mittels der eine visuelle Markierung (19) der Schaltfläche (7) darstellbar ist,
wobei die visuelle Markierung (19) in Abhängigkeit von der mittels des elektromechanischen Wandlers (9) erzeugbaren elektrischen Energiemenge (15) änderbar ist.

2. Mensch-Maschine-Schnittstelle nach Anspruch 1, wobei die Anzeigevorrichtung (17) zwischen der Schaltfläche (7) und dem elektromechanischen Wandler (9) angeordnet ist.

3. Mensch-Maschine-Schnittstelle nach einem der vorhergehenden Ansprüche 1 oder 2, mit einer dem elektromechanischen Wandler (9) nachgeschalteten und der Anzeigevorrichtung (17) vorgeschalteten Steuervorrichtung (21), wobei die visuelle Kennzeichnung (19) mittels der Steuervorrichtung (21) änderbar ist.

4. Mensch-Maschine-Schnittstelle nach dem vorhergehenden Anspruch 3, wobei die Steuervorrichtung (21) während eines Änderns der visuellen Markierung (19) ausschließlich durch die mittels des elektromechanischen Wandlers (9) erzeugbare elektrische Energiemenge (13) elektrisch versorgbar ist.

5. Mensch-Maschine-Schnittstelle nach einem der vorhergehenden Ansprüche 3 oder 4, wobei die Steuervorrichtung (21) einen dem elektromechanischen Wandler (9) nachgeschalteten Interrupteingang (27) aufweist, der durch die mittels des elektromechanischen Wandlers (9) erzeugbare elektrische Energiemenge (15) ansteuerbar ist.

6. Mensch-Maschine-Schnittstelle nach einem der vorhergehenden Ansprüche 3 bis 5, mit einer Hilfsenergiequelle (29) zum elektrischen Versorgen der Steuervorrichtung (21), wobei die Hilfsenergiequelle 29 mittels einer Schaltvorrichtung (31) von der Steuervorrichtung (21) abtrennbar ist, wobei die Schaltvorrichtung (31) dem elektromechanischen Wandler (9) nachgeschaltet und durch diesen steuerbar ist.

7. Mensch-Maschine-Schnittstelle nach einem der vorhergehenden Ansprüche, wobei die Anzeigevorrichtung (17) unter Einwirkung der Betätigungskraft (5) reversibel elastisch verformbar ist.

8. Mensch-Maschine-Schnittstelle nach einem der vorhergehenden Ansprüche, wobei der elektromechanische Wandler (9) einen druck- und/oder verformungsempfindlichen Sensor und/oder einen piezoresistiven Sensor und/oder einen Force Sensing Resistor (FSR) und/oder ein piezoelektrisches Element (11) aufweist und/oder die Darstellung mittels der Anzeigevorrichtung (17) im Wesentlichen stromlos erfolgt.

9. Verfahren zum Ändern einer visuellen Markierung (19) einer durch eine Betätigungskraft (5) betätigbaren Schaltfläche (7) einer Mensch-Maschine-Schnittstelle (1), mit:
- Bereitstellen eines elektromechanischen Wandlers (9) zum Wandeln einer mechanischen Energiemenge (13) in eine elektrische Energiemenge (15),
- Leiten der Betätigungskraft (5) von der Schaltfläche (7) auf den elektromechanischen Wandler (9), und dadurch
- Übertragen der von der Betätigungskraft (5) bewirkten mechanischen Energiemenge (13) auf den elektromechanischen Wandler (9),
- Wandeln der mechanischen Energiemenge (13) in die elektrische Energiemenge (15) mittels des elektromechanischen Wandlers (9),
- Ändern der visuellen Markierung (19) in Abhängigkeit von der mittels des elektromechanischen Wandlers (9) erzeugten elektrischen Energiemenge (15).

10. Verfahren nach dem vorhergehenden Anspruch 9, mit:
- Leiten der Betätigungskraft (5) von der Schaltfläche (7) auf eine Anzeigevorrichtung (17) zum Darstellen der Kennzeichnung und Weiterleiten der Betätigungskraft (5) von der Anzeigevorrichtung (17) auf den elektromechanischen Wandler (9).

11. Verfahren nach dem vorhergehenden Ansprüche 9 oder 10, mit:
- Wechseln einer Steuervorrichtung (21) zum Ändern der visuellen Markierung (19) von einem energiesparenden Betriebszustand in einen aktiven Betriebszustand in Abhängigkeit der mittels des elektromechanischen Wandlers (9) erzeugten elektrischen Energiemenge (15).

12. Verfahren nach dem vorhergehenden Anspruch 11, mit:
- Direktes Versorgen der Steuervorrichtung (21) mit der elektrischen Energiemenge (15) zum Ändern der visuellen Markierung (19) und dadurch gleichzeitiges Wechseln des Betriebszustandes der Steuervorrichtung (21).

13. Verfahren nach dem vorhergehenden Ansprüche 10 oder 11, mit:
- Steuern einer elektrischen Hilfsenergie (29), mittels der die Steuervorrichtung (21) elektrisch versorgbar ist, in Abhängigkeit von der mittels des elektromechanischen Wandlers (9) erzeugten elektrischen Energiemenge (15).

14. Verfahren nach einem der vorhergehenden Ansprüche 11 bis 13, mit:
- Auslösen eines Interrupts an der Steuervorrichtung (21) in Abhängigkeit von der mittels des elektromechanischen Wandlers (9) erzeugten elektrischen Energiemenge (15) zum Wechseln des Betriebszustandes.

15. Verfahren nach einem der vorhergehenden Ansprüche 9 bis 14, mit:
- Steuern einer Vorrichtung (3) in Abhängigkeit von der mittels des elektromechanischen Wandlers (9) erzeugten elektrischen Energiemenge (15).
